# EUROPEAN PATENT APPLICATION

(11) **EP 4 832 733 A1**
(43) Date of publication of application: **28.10.2026**
(21) Application number: 25172389.6
(22) Date of filing: 24.04.2025
(51) Int. Cl.: H10P 72/70

(54) **METHOD OF LIGHT-INDUCED TRANSFER OF AT LEAST ONE COMPONENT FROM A DONOR SUBSTRATE TO AN ACCEPTOR SUBSTRATE**

(71) Applicant: Nederlandse Organisatie voor toegepast- natuurwetenschappelijk onderzoek TNO, 2595 DA 's-Gravenhage (NL)
(72) Inventor: AKKERMAN, Hylke Broer, 2595 DA`s-Gravenhage (NL); GELINCK, Gerwin Hermanus, 2595 DA`s-Gravenhage (NL); KARKI, Akchheta, 2595 DA`s-Gravenhage (NL); OLLEARO, Riccardo, 2595 DA`s-Gravenhage (NL)
(74) Representative: V.O.

(57) **Abstract**

The present document relates to a method of light-induced transfer of at least one component from a donor substrate to an acceptor substrate using a light beam emitted by a light source. The donor substrate comprises an optically transparent carrier for transmitting the light beam and at least one release structure on the optically transparent carrier. The at least one release structure is configured for attaching the at least one component to the donor substrate and for releasing the component to the acceptor substrate when the release structure is exposed to optical energy from the light beam. The method comprises: positioning the component attached to the donor substrate opposite to a landing zone where the component is to be received; illuminating, using the light beam, the release structure through the optically transparent carrier for releasing the component, and receiving the component from the donor substrate on the landing zone of the acceptor substrate. Prior to attaching the component to the release structure, the method comprises providing at least one of the component and the landing zone with a support structure, for supporting by the support structure the component in a predetermined three-dimensional orientation with respect to the acceptor substrate, upon receiving the component on the landing zone.

## Description

### Field of the invention

The present invention is directed at a method of light-induced transfer of at least one component from a donor substrate to an acceptor substrate using a light beam emitted by a light source, wherein the donor substrate comprises an optically transparent carrier for transmitting the light beam, and at least one release structure on the optically transparent carrier, the at least one release structure being configured for attaching the at least one component to the donor substrate and for releasing the component to the acceptor substrate when the release structure is exposed to optical energy from the light beam, wherein the method comprises: positioning the component attached to the donor substrate opposite to a landing zone where the component is to be received; illuminating, using the light beam, the release structure through the optically transparent carrier for releasing the component, and receiving the component from the donor substrate on the landing zone of the acceptor substrate.

### Background

Innovation in the semiconductor industry continues to drive miniaturization of components. At the same time, increasing demands require not only smaller components but also higher throughput in production and assembly.

Some known methods of light-induced component transfer involve the components being placed onto acceptor substrates face-on. While effective, this approach limits design flexibility, particularly in photonic systems, and imposes constraints on how far semiconductor devices can be miniaturized and optimized.

Components may alternatively be placed edge-on, such that components are disposed vertically or at an angle relative to the substrate. This offers significant design advantages for applications such as micro-optic benches, vertical edge-emitting lasers, and quantum photonic circuits. Typically, edge-on placement is achieved through micromanipulation, which involves precise mechanical positioning of individual components. However, micromanipulation is inherently slow, labor-intensive, and difficult to scale, making it unsuitable for high-throughput manufacturing.

### Summary of the invention

It is an object of the present invention to provide a method which overcomes the abovementioned drawbacks and which enables component placement at high throughputs with a high degree of freedom in component orientation.

To this end, there is provided herewith a method of light-induced transfer of at least one component from a donor substrate to an acceptor substrate using a light beam emitted by a light source, wherein the donor substrate comprises an optically transparent carrier for transmitting the light beam, and at least one release structure on the optically transparent carrier, the at least one release structure being configured for attaching the at least one component to the donor substrate and for releasing the component to the acceptor substrate when the release structure is exposed to optical energy from the light beam, wherein the method comprises: positioning the component attached to the donor substrate opposite to a landing zone where the component is to be received; illuminating, using the light beam, the release structure through the optically transparent carrier for releasing the component, and receiving the component from the donor substrate on the landing zone of the acceptor substrate; wherein prior to attaching the component to the release structure, the method comprises providing at least one of the component and the landing zone with a support structure, for supporting by the support structure the component in a predetermined three-dimensional orientation with respect to the acceptor substrate, upon receiving the component on the landing zone.

Rather than using micro-manipulation of individual components until a desired orientation is achieved for each one, the present invention instead proposes to introduce a support structure for supporting components on the acceptor substrate in a predetermined three-dimensional orientation with respect to the acceptor substrate. Since the support structure will typically be provided prior to the component being attached to the donor substrate, the introduction of this support structure according to the invention bypasses the need for the slow process of altering the orientation of individual components, and enables to directly achieve three-dimensional orientations with respect to the acceptor substrate within the process of light-induced transfer of the components, enabling much faster edge-on placement of components. This is because the shape, dimensions and position of the support structure may be specifically tuned to the predetermined three-dimensional orientation that is to be achieved in the transfer process. The invention thus replaces a process of three-dimensional manipulation of the component with a process of controlling properties of the provided support structure. This process is far simpler and more easily scalable, enabling three-dimensional orientations of the component to be achieved more reliably and at high throughputs. Three-dimensional orientations may mean an angled orientation with respect to the acceptor substrate. In these embodiments, the invention not only is able to release the component onto the acceptor substrate on the side of the component which faces the acceptor substrate while it is still attached to the donor substrate, but advantageously is also able to release the components onto the acceptor substrate with e.g. an edge of one end of the component making direct contact with the acceptor substrate, while the component may be supported near an opposite end thereof by the support structure. But a three-dimensional orientation may additionally or alternatively mean a predefined height with respect to the acceptor substrate. In those embodiments, the support structure may enable the component to be released above the acceptor substrate rather than directly thereon. The invention in other words greatly increases the freedom and flexibility of component placements on acceptor substrates through the introduction of a support structure between the component and the acceptor substrate. The support structure may be introduced to either one or both of the landing zone of the acceptor substrate and the component to be transferred. In other words, in some embodiments the component is provided with a the support structure, in other or further embodiments the support structure is provided to the acceptor substrate at least partially in the landing zone, and in yet other or further embodiments both the component and the acceptor substrate are provided with the support structure. In the latter case, the support structures on the component and on the acceptor substrate may be configured for cooperating with each other such as to establish a secure or fixed connection between the component and the acceptor substrate. The support structure, or surface structure, may be provided via various methods. Examples include etching, which allows precise patterning of features such as steps, recesses, or inclined surfaces on the acceptor substrate. Alternatively, the support structure may be formed through additive manufacturing methods, such as material deposition, to create protrusions or anchoring points, or via molding. The support structure may typically be provided before the component is attached to the donor substrate, allowing a desired orientation of the component to be defined beforehand. This enables the transfer process according to the method of the invention to be carried out quickly. When executing the method according to the invention, the at least one component may then be attached to the donor substrate via the release structure. The method may be applied to many light-induced transfer techniques; the release structures may utilize various processes to facilitate the attachment and release of the components to and from the donor substrate. For example, the optical energy may generate heat in the release structure and subsequently initiate a process of de-wetting that causes a loss of adhesion between the component and the donor substrate. Alternatively, the release structure may contain photoresists including for example photoacid generators or photobase generators. The optical energy from the light beam would then catalyze a chemical reaction changing the solubility of the materials in the release structures in order to facilitate the release of the components to the acceptor substrate. The method according to the first aspect of the invention is therefore highly versatile. Once the at least one component is attached to the donor substrate, the at least one component is positioned in a transfer position (opposite to) a respective landing zone for the or each component and the at least one release structure is subsequently illuminated using the light beam from the light source. This opposite positioning may include situations in which the component is orthogonally oriented towards the landing zone prior to transfer, but may also include situations in which this orientation is at an angle. It may further include situations in which prior to transfer the component already makes contact with the landing zone. The component is then received in the landing zone on the acceptor substrate in the predefined three-dimensional orientation as described above. Typically, the donor substrate may be brought, during the method, above the acceptor substrate, with the components "hanging" between the donor substrate and the acceptor substrate via the release structures. The at least one component may then be induced to move toward the acceptor substrate by gravity once released from the release structures. In some cases, there may be a degree of uncertainty or error in the orientation in which the at least one component is release onto the acceptor substrate. However, in those case the support structure may still correct for this uncertainty or error, for example via a rotation of the component about the support structure and onto the acceptor substrate. In other words, in those cases the support structure, which may locally establish contact between the component and the acceptor substrate before the component is able to reach the acceptor substrate in full, may serve as a hinge such as to allow the at least one component to assume its predetermined three-dimensional orientation. Advantageously, there may be a single component released in the method of the invention, or multiple - even a plurality of components may be released in the method according to the invention. Each of the plurality of components may then be supported by a different support structure, each of which may have varying designs, shapes and dimensions, further enhancing the freedom afforded by the invention. Moreover, the plurality of components may be released simultaneously onto the acceptor substrate, further increasing the potential for high throughput.

In accordance with some embodiments of the invention, the support structure is provided to the at least one component, wherein at least one of: the support structure is provided at an offset from a center of the component; and the support structure is shaped to yield, upon receiving of the component on the landing zone, a contact point of the support structure and the acceptor substrate at an offset from a center of mass of the component. In these embodiments, the support structure is provided to the component, and will therefore be fixed with respect to the component during the step of positioning the component attached to the donor substrate opposite to the landing zone where the at least one component is to be achieved. This is an advantageous aspect of these embodiments in its own right, because the fixed connection between the support structure and the component in these embodiments reduces the need for careful alignment of components opposite to landing zones, which can be associated with critical uncertainties or errors. These embodiments reduce this risk by having the support structure fixed with respect to the components prior to the components being released. Moreover, in some of these embodiments the support structure may be provided at an offset from a center of mass of the component. This is an advantageous means of achieving an angled three-dimensional orientation of the component on the acceptor substrate, because the offset from the center of mass of the component will aid the component in assuming its desired orientation as the force which pulls the component onto the acceptor substrate induce a torque for this purpose. Additionally or alternatively, the support structure may be shaped to yield a contact point between the support structure and the acceptor substrate. For example, the support structure may have an asymmetric shape while still being provided onto the center of mass of the component. The asymmetric shape in that case would still allow the component to assume an angled three-dimensional orientation on the acceptor substrate, because the contact point between the support structure, which in these embodiments was already fixed to the component, and the acceptor substrate is at an offset from the center of mass of the component. These embodiments thus provide another advantageous means of achieving an angled three-dimensional orientation of the component.

In accordance with some embodiments of the invention, the support structure is provided to the acceptor substrate, and wherein, in the step of positioning the component opposite to the landing zone, the support structure is positioned at the offset from the center of the component. In these embodiments, the support structure is provided to the acceptor substrate and achieving the predetermined three-dimensional orientation may involve positioning or careful alignment of the component attached to the donor substrate, opposite to the landing zone of the acceptor substrate. The support structure may be a surface feature positioned at least partially within the landing zone, such as a projecting structure, a step, or a trench. The support structure may be shaped for receiving the component in a specific orientation. The support structure may be functionalized for holding the component securely in place. These embodiments thus provide an advantageous means of achieving desired predefined three-dimensional orientations of the component on the acceptor substrate.

In accordance with some embodiments of the invention, prior to providing the support structure, the method comprises determining the predetermined three-dimensional orientation of the at least one component and defining, based on the predetermined three-dimensional orientation and on at least one of a shape and dimensions of the at least one component, a shape and a position of the support structure. In these embodiments, various parameters may be tuned and optimized in order to obtain a high degree of control and accuracy in the placement of components onto acceptor substrates. Once the desired three-dimensional orientation of the component is determined, the method in these embodiments of the invention may take into account the shape or dimensions of the component in order to provide a support structure specifically designed in terms of shape, size and position such as to approximate, as close as possible, the predetermined three-dimensional orientation of the at least one component on the acceptor substrate. This is also highly scalable; by controlling the shape or position of each of a plurality of support structures, a high degree of control and accuracy may be obtained for the simultaneous release of many components onto the acceptor substrate. In other words, the scalability of these embodiments also extends advantageously to the potential for high throughputs.

In accordance with some embodiments of the invention, either one of: the support structure projects from the acceptor substrate; or the support structure is a recess in the acceptor substrate. The support structure in these embodiments may be formed by the local topology of the acceptor substrate, in particular inside of the landing zone where the component is to be released. In these embodiments, the desired three-dimensional orientation of the component may already be taken into account during preparation of the acceptor substrate, enhancing the efficiency of the process as a whole. This is because these embodiments of the invention remove the need for adding an additional support structure after the acceptor substrate has already been prepared. The projecting structure or recess may for example define a height difference within the landing zone wherein the component is to be released, and in that way enable the component to be received on the acceptor substrate in the desired three-dimensional orientation. Alternatively, the projecting structure may be a pillar, a wall, or another surface feature of the acceptor substrate that may be advantageously prepared during preparation of the acceptor substrate beforehand. Similarly, in accordance with some embodiments of the invention, either one of: the support structure projects from component; or the support structure is a recess in the component. Similar effects may thus be achieved through such pre-preparation of the component rather than the acceptor substrate.

In accordance with some embodiments of the invention, a height of the support structure is defined based on the at least one of the shape and dimensions of the at least one component, such as to suspend, upon the transfer, the at least one component from the support structure on the acceptor substrate, for example from a side wall or slanted wall of the support structure For example, the component may have a rectangular shape having a certain length. This length of the component may be known prior to the support structure for that component being provided. This length may therefore be taken into account in the design of the support structure to be provided. The support structure may for example be provided as a trench in the surface of the acceptor substrate, with a wall of the trench being located inside of the landing zone where that component is to be released. The height of this wall may then be defined based on the known length of the component, such as to suspend the component from this wall after execution of the method according to these embodiments of the invention. In this particular case, the wall of the component may advantageously be defined to be higher than the length of the component. Furthermore, the component during execution of the method according to these embodiments may be positioned such as to align an edge of the component to the edge of the wall. Once the component is then released onto the landing zone in the acceptor substrate, the edge of the component may be received at the edge of the wall. The support structure may be functionalized for establishing a secure local connection upon receipt of the component thereon. In some examples, the component may then rotate about the contact point where the component is received onto the wall and, since the wall was defined in this example to be higher than the length of the component, the component can suspend from the support structure, leaving some space between the free end portion of the component that had rotated about the contact point, and the surface of the acceptor substrate. This space may then advantageously be occupied by other components or parts of a device manufactured using the method according to these embodiments. In other words, these embodiments advantageously enhance the potential for three-dimensional assembly of devices.

In accordance with some embodiments of the invention, the support structure comprises one of a group comprising: inclined walls, vertical walls, and stepped walls, rectangular shapes, rounded shapes, polygonal shapes. Any of these examples may provide an advantageous means of achieving the predetermined three-dimensional orientation of the at least one component. In some embodiments, a same support structure may be large enough to occupy multiple landing zones for different support structures.

In accordance with some embodiments of the invention, prior to attaching the component to the release structure, the method comprises providing either one of the component and the landing zone with a further support structure for connecting the component to the acceptor substrate at an opposite end of the component with respect to the support structure, and wherein upon connecting the component to the further support structure, the further support structure locally establishes a connection between the component and the acceptor substrate, for fixing the at least one component in the predetermined three-dimensional orientation. In these embodiments, components may form a bridge between the support structure and the further support structure. In those cases, a space under the bridge may advantageously be defined which may subsequently (or prior to the bridge being formed) be filled with another component or part of a device or product manufactured using the method according to these embodiments. These embodiments thus advantageously enhance the potential for three-dimensional assemblies to be produced using this method. The connection between components and further support structure help fix the components in the predetermined three-dimensional orientations because the connection reduces the ability of components to move after being received on the acceptor substrate. In some of these embodiments for example, the further support structure may have a different height than the support structure. In those embodiments, the component may be received in the landing zone by the support structure and by the further support structure at the different heights. This is an advantageous means of achieving an angled three-dimensional orientation of the component on the acceptor substrate. Alternatively, those embodiments may also advantageously enable a complexly shaped component to be supported on the acceptor substrate in specific three-dimensional orientations which may be difficult or impossible to achieve using only a single support structure. These embodiments thus increase the control over the orientations that may be achieved for components released onto acceptor substrates using this method. In some embodiments, both the support structure may be provided to the component. In other or further embodiments, the support structure may be provided to the component, while the further support structure may be provided to the acceptor substrate, or vice versa. In yet further embodiments, both the support structure and the further support structure may be provided to the acceptor substrate. Each of these examples provide advantageous alternatives to achieve the abovementioned advantages.

In accordance with some embodiments of the invention, prior to attaching the component to the release structure, the method comprises providing at least one of the component, the landing zone and the support structure with an adhesive coating, such as to locally establish, upon receiving the component on the landing zone, a fixed connection between the component and the acceptor substrate via the support structure. This is an advantageous means of functionalizing the component, the acceptor substrate or the support structure for establishing a fixed or secure connection between the component and the acceptor substrate via the support structure, because it allows this connection to be established upon receipt of the component in the landing zone. In other words, no further active steps would be required in these embodiments to ensure that the component remains in its intended location and in its desired three-dimensional orientation after it has been thusly released.

In accordance with some embodiments of the invention, the or each release structure is formed by a stack of layers comprising: an absorption layer for absorbing optical energy from the light beam, the absorption layer having a first melting temperature; a melting layer for being melted by heat from the absorption layer, the melting layer having a second melting temperature below the first melting temperature; and an adhesive layer for adhering the component to the melting layer, and for releasing the adhesion when the melting layer is in a molten state. The adhesive layer of the release structure in these embodiments typically is composed of polymeric materials, which give the layer a high bonding strength to components. This makes the composition of the release structure according to these embodiments highly suitable for being applied in the invention. The light beam propagates through the optically transparent carrier, and may then be incident on the absorption layer of the release structure. In the absorption layer, the optical energy of the light beam may then be absorbed, such that the absorption layer generates heat therein. The heat in the absorption layer then melts the melting layer of the release structure and brings it into a molten, liquid state. The melting temperature of the absorption layer may be higher than the melting temperature of the melting layer, such that the absorption layer can remain solid while the melting layer is melted. Once the melting layer is in a molten state, release of the component, which may adhere to the release structure via the adhesion layer, may occur via a process of de-wetting. The surface energy of the absorption layer may be higher than the surface tension of the molten melting layer. At the same time, the surface tension of the molten melting layer may be higher than the surface energy of the adhesion layer. Therefore, when the melting layer of the release structures is molten, adhesion between the absorption layers and melting layers may be maintained, but adhesion between the melting layers and the adhesion layers may be lost, resulting in the release of the component onto the acceptor substrate.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figures 1A and 1B schematically illustrate the receipt of components onto the acceptor substrate using a support structure in accordance with two embodiments of the invention.
Figure 2 schematically illustrates the method in accordance with some embodiments of the invention.
Figures 3A and 3B schematically illustrate various examples of support structures used for achieving predetermined three-dimensional orientations of a component, in accordance with some embodiments of the invention.
Figures 4A-4C illustrate various further examples of support structures used for achieving predetermined three-dimensional orientations of a component, in accordance with some further embodiments of the invention.
Figure 5 schematically illustrate a release structure in accordance with some embodiments of the invention.

### Detailed description

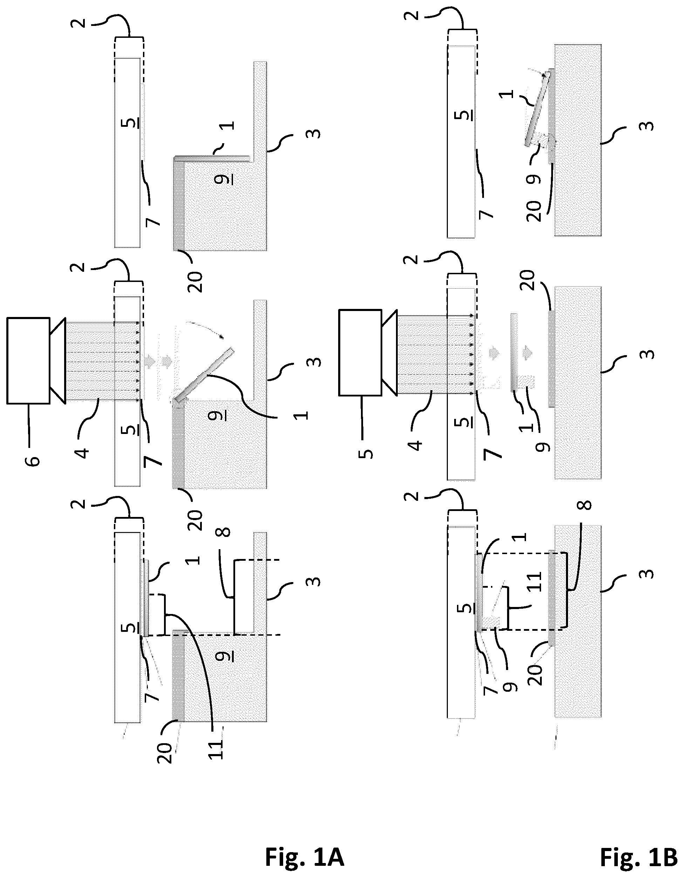

Figure 1A schematically illustrates a release of a component 1, which is attached via a release structure 7 to an optically transparent carrier 5 to a donor substrate 2, to an acceptor substrate 3 using a method in accordance with an embodiment of the invention. In the method, the component 1 is positioned opposite a landing zone 8 of the acceptor substrate 3, which landing zone 8 is provided in this embodiment with a support structure 9 for supporting the component 1 in a predetermined three-dimensional orientation on the landing zone 8 of the acceptor substrate 3. In this embodiment, the support structure 9 is provided to the acceptor substrate 3 and introduces a height difference within the landing zone 8 of the acceptor substrate 3. When the component 1 has been properly positioned relative to the acceptor substrate 3, the edge of the support structure 9 is positioned for receiving the edge of the component 1. The method then involves using a light beam 4 emitted by a light source 6 to illuminate the release structure 7 which prior to that moment keeps the component 1 attached to the donor substrate 2, opposite to the landing zone 8, such as to thereby induce the release structure 7 to release the component 1 onto the acceptor substrate 3. Typically, the component 1 may then move in the direction of the acceptor substrate 3 through the influence of gravity on the component 1, but alternative embodiments may be envisioned in which a different force, e.g. a magnetic force, may be used for this purpose. As the component 1 moves toward the acceptor substrate 3, the edge thereof which was positioned in alignment with the edge of the support structure 9 may then be received by said edge of support structure 9. In this embodiment, the support structure 9 was additionally functionalized for receiving the component and for establishing locally a fixed connection with the component, by providing said support structure 9 with an adhesive coating 20. This adhesive coating 20 exhibits a bonding strength with the component 1 which is sufficiently large that it ensures the edge of the component stays attached to the support structure 9, while simultaneously allowing the component 1 to subsequently start rotating about the point of contact between the component 1 and support structure 9. Alternative embodiments may also be envisioned in which e.g. the component rather than the support structure 9 is provided with adhesive coating 20. In this embodiment, the support structure 9 was further defined to be larger than the length of the component 1. This allows the component 1 to rotate a full range (the full range in this example being 90 degrees), such as to suspend the component 1 above the acceptor substrate 3.

Figure 1B schematically illustrates an alternative embodiment of the invention. In this embodiment, support structure 9 is not part of the acceptor substrate 3, but instead is provided to the component 1. Typically, in embodiments such as the present one support structures 9 may be provided to components 1 prior to the component 1 being attached to the donor substrate 2. This may be done via additive methods, but alternatively may also be done via e.g. etching. Similarly to figure 1A where the support structure 9 on the acceptor substrate 3 is located at an offset 11 from the center of mass of the component 1, in figure 1B the support structure 9 is also provided at offset 11 from the center of mass of the component 1. This is an advantageous means of achieving an angled three-dimensional orientation of the component 1 on the acceptor substrate 3. In alternative embodiments however, a support structure 9 may instead be provided in alignment with the center of mass of component 1. Rather than achieving an angled three-dimensional orientation, in those alternative embodiments a heightened three-dimensional orientation of the component 1 on the acceptor substrate 3 may be achieved. In figure 1B, as the component 1 moves toward the acceptor substrate 3 after being released by the release structure 7 upon illumination, adhesive coating 20 on the acceptor substrate 3 receives the support structure 9. At that moment, the component 1 is locally fixed to the acceptor substrate 3 via the support structure 9 and through the bonding of adhesive coating 20. Component 1 in this embodiments then rotates about this contact point onto the acceptor substrate 3 until the opposite end of the component 1 also makes contact with the adhesive coating 20 on the acceptor substrate. The component 1 is then securely connected at both ends thereof to the acceptor substrate 3.

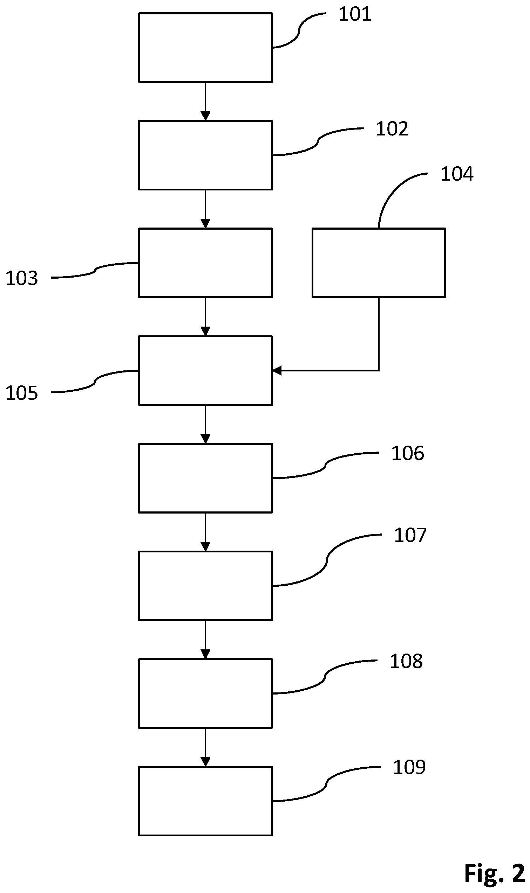

Figure 2 schematically illustrates a method in accordance with some embodiments of the invention. Given a component 1, or a number of components 1 to be released onto an acceptor substrate 3, the method may involve determining 101 the desired three-dimensional orientation for the or each component 1 when released onto the acceptor substrate 3. Once a step of determining 101 this desired orientation has been executed, the method subsequently involve a step of defining 102 the shape and position of the support structure. This step may be performed taking into account both the dimensions or shape of the component or components 1 to be transferred, and the desired orientation thereof defined in the previous step 101. Once the shape and position of the support structure 9 have been defined, the method may proceed to providing 103 the support structure to either one or both of the component 1 and the acceptor substrate 3, and optionally to providing 104 a further support structure to either one or both of the component 1 and acceptor substrate 3. The method at that point may also involve providing a further support structure 90 (further discussed below). Additionally, at least one of the component 1, the support structure 9 and/or further support structure 90, and the acceptor substrate may be provided 105 with an adhesive coating 20 in order to functionalize the various parts involved in the method for establishing a fixed connection between the component 1 and the acceptor substrate 3. Once the components 1 and the acceptor substrate 3 are ready for the transfer process, the method may proceed to attach 106 the components 1 to the donor substrate 2 using release structure 7. With the components 1 attached via release structures 7 to the donor substrate 2, the components 1 may be positioned 107 opposite to a landing zone 8 on the acceptor substrate 3, where the components 1 are to be released. After proper positioning 107, the method involves illuminating 108 the release structures 7 through the optically transparent carrier 6 in order to induce the release structures 7 to release the components 1 from their attachment thereto. At that point the components 1 may move toward the acceptor substrate 3 and will be received 109 on the acceptor substrate 3.

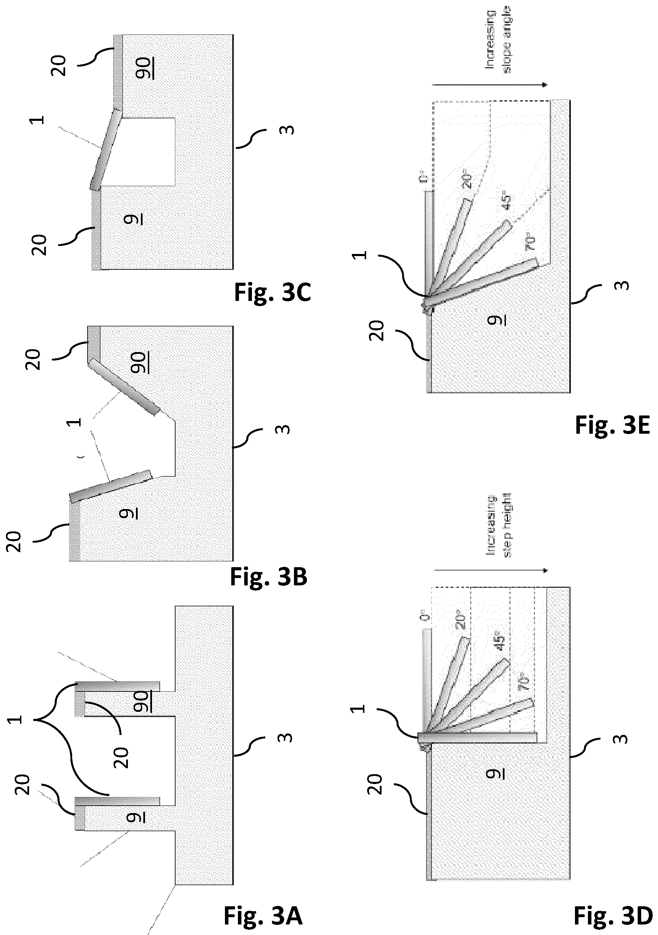

Figure 3A schematically illustrates various support structures 9 and further support structures 90 provided on an acceptor substrate 3. In figure 3A, support structure 9 and further support structure 90 both have received a separate component 1 with their respective adhesive coatings 20. In that example, the heights of the support structure 9 and the further support structure 90 were defined to be greater than the length of the components 1. Moreover, the spacing between the support structure 9 and the further support structure 90 was also defined to be greater than the length of the component 1. Defining these dimensions thusly enables the components 1 to be suspended from the support structure 9 and from the further support structure 90, above the acceptor substrate 3. In figure 3B, the support structure 9 and further support structure 90 both comprise slanted walls, which additionally are of different heights. These differences between the support structure 9 and further support structure 90 mean that the components 1 will be suspended from the two respective structures in different three-dimensional orientations, both in terms of height and in terms of angular orientation, even though the components 1 themselves may be identical and may even be identically attached to the donor substrate prior to the release structures 7 being illuminated for release of the components. This example in other words illustrates the freedom and control in component placement obtained in this embodiment of the invention. In figure 3C, the support structure 9 and the support structure 90 cooperate with each other to support a same component 1. This is in contrast with the other two examples of this figure, in which both structures support separate components 1, respectively in identical or different three-dimensional orientations. In this last example, the support structure 9 and further support structure 90 again have different heights, allowing the component 1 to be supported in an angled three-dimensional orientation above the acceptor substrate 3. Furthermore, the component 1 in this example forms a bridge between the two structures, defining a space underneath the bridge that may optionally be used to accommodate another component or part. This embodiment thus creates greater potential for three-dimensional assembly design. Figures 3D and 3E schematically illustrate how defining the properties of a support structure 9 may influence the final three-dimensional orientation of the component 1. In both examples, the support structure is provided to the acceptor substrate 3, which is additionally provided here with an adhesive coating 20. When executing the method according to the invention, the component 1 may be positioned opposite to the acceptor substrate 3, such that upon release from a donor substrate 2, the edge of the component 1 is received by the support structure 9, as shown in both examples. In figure 3D, the support structure 9 has a vertical wall, making a full range of rotation of the component about the contact point between the component 1 and the support structure 9 90 degrees. However, in figure 3E, because that support structure 9 has a slanted wall, the range of rotation of the component 1 is limited to 70 degrees. In alternative embodiments, the range of rotation may be further limited by a smaller height of the support structure 9, in particular relative to the length of the component 1.

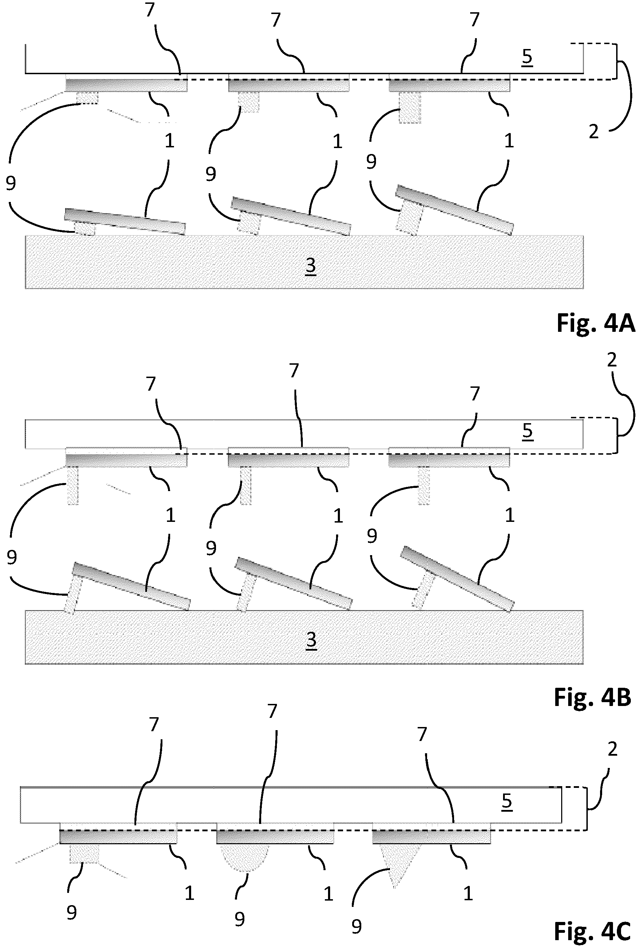

Figures 4A-4C schematically illustrate some examples of how different shapes, sizes or positions of support structure 9 may impact the final orientation of component 1. In these figures, the support structure 9 is provided to the components 1. In figure 4A, it can be seen that a longer support structure 9 may result in a steeper angled orientation of the component 1 on the acceptor substrate. Figure 4B schematically shows how the location of the support structure 9 relative to the center of mass of the component 1 impacts the orientation of the component 1 on the acceptor substrate 3, in particular that a support structure 9 closer to the center of mass of the component 1 may result in a steeper angled orientation. Figure 4C shows support structures 9 provided to components 1 having various shapes - in this case, rectangular, rounded and triangular, as defined within the plane of the figure. A length of the rectangular structure 9, or a radius of the rounded support structure 9, or lengths of the sides of the triangular support structure may similarly provide three-dimensional orientations of the component 1 with different angles. Moreover, in cases where e.g. the acceptor substrate 3 is provided with an adhesive coating 20, the shape of the support structure may also impact the bonding strength yielded by the adhesive coating, since the shape of the support structure also would affect the contact area between the support structure 9 and the adhesive coating 20 in those embodiments. This may then subsequently affect the ability of the component to rotate about the point of contact and by extension would affect the three-dimensional orientation of the component 1. From this figure, it may be further appreciated that multiple components 1 may be released simultaneously from the donor substrate 2 through simultaneous illumination of the release structures 7. In embodiments where support structures 9 are provided to the acceptor substrate 3, a same support structure 9 may also serve to support multiple of the components 1 to be released.

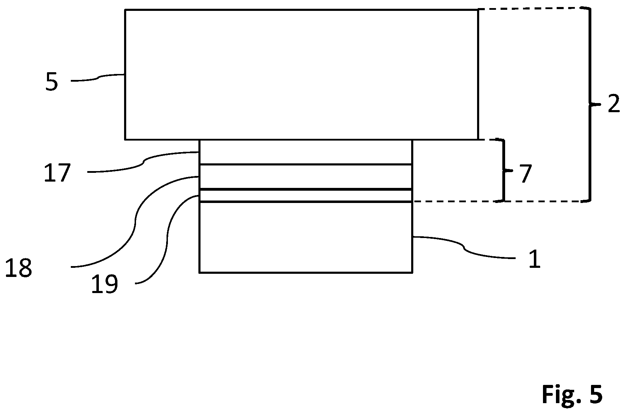

Figure 5 schematically illustrates a component 1 attached to a donor substrate 2 in accordance with an embodiment of the invention. In this embodiment, the release structure 7 comprises a stack of layers. The stack includes an absorption layer 17, which receives optical energy from the light beam 4 through the optically transparent carrier 5 and consequently generates heat therein. The heat in these embodiments consequently melts the melting layer 18 and brings it into a molten, liquid state. The melting temperature of the absorption layer 17 may in these embodiments be higher than the melting temperature of the melting layer 18, such that the absorption layer 17 can remain solid while the melting layer 18 is melted. Once the melting layer is in a molten state, release of the component 1, which may adhere to the release structure via the adhesion layer 19, may in these embodiments occur via a process of de-wetting. The surface energy of the absorption layer 17 may be higher than the surface tension of the molten melting layer 18. At the same time, the surface tension of the molten melting layer 18 may be higher than the surface energy of the adhesion layer 19. Therefore, when the melting layer 18 is molten, adhesion between the absorption layer 17 and melting layer 18 may be maintained, but adhesion between the melting layer 18 and the adhesion layer 19 may be lost, resulting in the release of the component 1.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Method of light-induced transfer of at least one component from a donor substrate to an acceptor substrate using a light beam emitted by a light source, wherein the donor substrate comprises an optically transparent carrier for transmitting the light beam, and at least one release structure on the optically transparent carrier, the at least one release structure being configured for attaching the at least one component to the donor substrate and for releasing the component to the acceptor substrate when the release structure is exposed to optical energy from the light beam,
wherein the method comprises:
positioning the component attached to the donor substrate opposite to a landing zone where the component is to be received;
illuminating, using the light beam, the release structure through the optically transparent carrier for releasing the component, and receiving the component from the donor substrate on the landing zone of the acceptor substrate;
wherein prior to attaching the component to the release structure, the method comprises providing at least one of the component and the landing zone with a support structure, for supporting by the support structure the component in a predetermined three-dimensional orientation with respect to the acceptor substrate, upon receiving the component on the landing zone.

2. Method according to claim 1, wherein the support structure is provided to the at least one component, wherein at least one of:
- the support structure is provided at an offset from a center of mass of the component; and
- the support structure is shaped to yield, upon receiving of the component on the landing zone, a contact point of the support structure and the acceptor substrate at an offset from a center of mass of the component.

3. Method according to claim 1 or 2, wherein either one of:
- the support structure projects from component; or
- the support structure is a recess in the component.

4. Method according to claim 1, wherein the support structure is provided to the acceptor substrate, and wherein, in the step of positioning the component opposite to the landing zone, the support structure is positioned at the offset from the center of the component.

5. Method according to any of the claims 1-4, wherein prior to providing the support structure, the method comprises determining the predetermined three-dimensional orientation of the at least one component and defining, based on the predetermined three-dimensional orientation and on at least one of a shape and dimensions of the at least one component, a shape and a position of the support structure.

6. Method according to claim 4 or 5, wherein either one of:
- the support structure projects from the acceptor substrate; or
- the support structure is a recess in the acceptor substrate.

7. Method according to claim 5 or 6, wherein a height of the support structure is defined based on the at least one of the shape and dimensions of the at least one component, such as to suspend, upon the transfer, the at least one component from the support structure, for example from a side wall or slanted wall of the support structure.

8. Method according to any of the preceding claims, wherein the support structure comprises one of a group comprising: inclined walls, vertical walls, and stepped walls, rectangular shapes, rounded shapes, polygonal shapes.

9. Method according to any of the preceding claims, wherein prior to attaching the component to the release structure, the method comprises providing either one of the component and the landing zone with a further support structure for connecting the component to the acceptor substrate at an opposite end of the component with respect to the support structure,
and wherein upon connecting the component to the further support structure, the further support structure locally establishes a connection between the component and the acceptor substrate, for fixing the at least one component in the predetermined three-dimensional orientation.

10. Method according to any of the preceding claims, wherein prior to attaching the component to the release structure, the method comprises providing at least one of the component, the landing zone and the support structure with an adhesive coating, such as to locally establish, upon receiving the component on the landing zone, a fixed connection between the component and the acceptor substrate via the support structure.

11. Method according to any of the preceding claims, wherein the or each release structure is formed by a stack of layers comprising:
- an absorption layer for absorbing optical energy from the light beam, the absorption layer having a first melting temperature;
- a melting layer for being melted by heat from the absorption layer, the melting layer having a second melting temperature below the first melting temperature; and
- an adhesive layer for adhering the component to the melting layer, and for releasing the adhesion when the melting layer is in a molten state.
